# EUROPÄISCHE PATENTSCHRIFT

(11) **EP 1 159 227 B1**
(45) Veröffentlichungstag und Bekanntmachung des Hinweises auf die Patenterteilung: **17.08.2005**
(21) Anmeldenummer: 00990741.1
(22) Anmeldetag: 14.12.2000
(51) Int. Cl.: C03B 19/09, C30B 15/10, C30B 35/00, C03C 3/06

(54) **VERFAHREN ZUR HERSTELLUNG EINES QUARZGLASTIEGELS**
METHOD FOR THE PRODUCTION OF A QUARTZ GLASS CRUCIBLE
PROCEDE DE FABRICATION D'UN CREUSET EN VERRE DE QUARTZ

(30) Priorität: 22.12.1999 DE 19962449
(43) Veröffentlichungstag der Anmeldung: 05.12.2001
(73) Patentinhaber: Heraeus Quarzglas GmbH & Co. KG, 63450 Hanau (DE)
(72) Erfinder: WERDECKER, Waltraud, 63456 Hanau (DE); LEIST, Johann, 63674 Altenstadt (DE)
(86) Internationale Anmeldenummer: PCT/EP2000/012686
(87) Internationale Veröffentlichungsnummer: WO 2001/046077

(56) Entgegenhaltungen:
- EP-A- 0 319 031
- EP-A- 0 463 543
- DE-A- 4 440 104
- DE-A- 19 710 672
- PATENT ABSTRACTS OF JAPAN vol. 16, no. 470, 30. September 1992 (1992-09-30) & JP 04 170387 A (SHIN-ETSU QUARTZ PRODUCTS CO LTD), 18. Juni 1992 (1992-06-18)

## Beschreibung

Die Erfindung betrifft ein Verfahren zur Herstellung eines Quarzglastiegels, durch Bereitstellen einer um eine Rotationssachse rotierbaren und eine Innenwandung aufweisenden Form, Einbringen von SiO₂-Körnung in die Form unter Bildung einer Körnungsschicht auf der Innenwandung der Form, und Erhitzen der Körnungsschicht von Innen nach Außen unter Rotation der Form und unter Bildung eines verglasten Tiegelkörpers mit opaker Außenzone.

In der DE-A1-44 40 104 ist ein Quarzglastiegel beschrieben. Der bekannte Quarzglastiegel besteht aus einem Tiegel-Grundkörper mit einer opaken Außenzone, die radial nach Innen in eine glatte, verschleißfeste, dichte Innenzone übergeht. Die Dicke der Innenzone liegt im Bereich von 1 bis 2 mm und ihre Dichte bei mindestens 2,15 g/cm³. Der Quarzglastiegel wird nach dem Schlickergußverfahren hergestellt. Hierzu wird Quarzglas unter Zugabe von Wasser zu einem pulverförmigen Material mit einer Teilchengröße unterhalb von 70 µm zerkleinert. Der dabei entstehende Schlicker wird in eine Gips-Negativform des Quarzglastiegels gegossen und der nach dem Trocknen erhaltene Tiegel-Rohling bei einer Temperatur von 1350°C bis 1450°C gesintert. Nach dem Sintern werden ausgewählte Flächenbereiche des opaken und porösen Tiegel-Grundkörpers einer weiteren Temperaturbehandlung im Bereich von 1650 °C bis 2200 °C unterzogen, um das poröse, opake Grundmaterial in transparentes Quarzglas mit einer Dichte von mindestens 2,15 g/cm³ umzuwandeln. Auf diese Wiese erhält der Tiegel-Grundkörper die erwähnte opake Außenzone, die radial nach Innen in die glatte, verschleißfeste, dichte Innenzone übergeht.

Ein Verfahren der eingangs genannten Gattung ist aus der DE-C-197 10 672 bekannt. Darin wird die Herstellung eines Quarzglastiegel zum Ziehen eines Silizium-Einkristalls nach dem Czrochralski-Verfahren nach dem sogenannten "Einstreuverfahren" beschrieben. Hierbei wird zunächst an der Innenwandung einer rotierenden Schmelzform eine Körnungsschicht aus der natürlichen Quarzkömung gebildet und unter Bildung eines undurchsichtigen Basiskörpers verglast. Zur Erzeugung einer transparenten, glatten Innenschicht wird daraufhin synthetisches Quarzglaspulver in die Schmelzform eingestreut, das sich auf der Innenwandung des Basiskörpers niederschlägt und mittels eines Lichtbogens zu der dichten, transparenten Innenschicht aufgeschmolzen wird. Der so hergestellte Quarzglastiegel besteht somit aus einem, undurchsichtigen Basiskörper und einer transparenten, dichten Innenschicht, die die Innenoberfläche des Quarzglastiegels bildet. Das Ausgangsmaterial für die Innenschicht unterscheidet sich von demjenigen, aus dem der Basiskörper besteht. Die Innenschicht, die in einem separaten Verfahrensschritt erzeugt wird, dient vorallem dazu, eine Migration von Verunreinigungen aus dem Basiskörper bis zur Innenoberfläche zu verhindern.

Der eingangs beschriebene Quarzglastiegel ist aufgrund seiner Verunreinigungsgehalte für einen Einsatz, bei dem es auf hohe Reinheit ankommt, nicht geeignet. Die Herstellung der transparenten Innenzone erfordert eine aufwendige zusätzliche Temperaturbehandlung. Die lichtundurchlässige Außenzone ist im wesentlichen für Licht aus dem sichtbaren Spektralbereich undurchlässig, im infraroten Spektralbereich (im folgenden auch als IR-Bereich bezeichnet) jedoch weitgehend transparent. Die Strahlungsverluste im IR-Bereich bewirken einen deutlichen Temperaturgradienten über der Tiegelwandung. Eine Kompensation der Strahlungsverluste durch Anheben der Temperatur der Schmelze innerhalb des Tiegels kann jedoch zu einer Erweichung und Verformung und zu einem Einsacken der Tiegelwandung und damit zu einer verringerten Tiegel-Standzeit führen. Dieses Problem macht sich vorallem bei Tiegeln mit großem Innenvolumen, die üblicherweise länger im Einsatz sind als kleinere Tiegel, bemerkbar.

Auch das beschriebene Verfahren zur Herstellung eines Quarzglastiegels nach dem Einstreuverfahren erfordert eine separaten Verfahrensschritt zur Herstellung der Innenschicht uns ist somit ebenfalls aufwendig.

Ein weiteres Verfahrten zur Herstellung eines Quarzglastiegels mittels Einstreuverfahren ist aus EP-A-0 463 543 bekannt. Hierbei wird für die opake Außenzone des Tiegels ein Körnung aus natürlichem Quarzglas oder aus einer Mischung aus natürlichem und synthetischem Quarzglas verwendet. Die transparente Innenschicht dagegen wird bevorzugt aus einer synthetischen Quarzglaskömung hergestellt, die hochrein ist und einen relativ geringen OH-Gehalt aufweist. Bei dem bekannten Verfahren erfolgt die Herstellung der Außenzone üblicherweise in einem von der Herstellung der transparenten Innenschicht getrennten Verfahrensschritt. Sofern für die opake Außenzone und die transparente Innenzone die gleiche Mischung aus natürlicher und synthetischer Quarzglaskörnung verwendet wird, muss in aufwendiger Weise die Temperatur beim Herstellprozess kontrolliert werden bzw. eine Kühlung für die Außenzone vorgesehen werden.

Der Erfindung liegt die Aufgabe zugrunde, ein einfaches, kostengünstiges Verfahren für die Herstellung eines Quarzglastiegels anzugeben, der sich durch hohe Reinheit und hohe Opazität, d.h. niedrige Transmission, im IR-Bereich auszeichnet.

Die oben angegebene Aufgabe wird ausgehend von dem eingangs genannten Verfahren erfindungsgemäß dadurch gelöst, daß als SiO₂-Körnung ein aus mindestens teilweise porösen Agglomeraten synthetisch hergestellter SiO₂-Primärteilchen gebildetes SiO₂-Granulat eingesetzt wird, das eine spezifische Oberfläche (nach BET) im Bereich von 0,5 m²/g bis 40 m²/g und ein Stampfdichte von mindestens 0,8 g/cm³ aufweist, wobei das Erhitzen derart erfolgt, daß unter Ausbildung einer Innenzone aus transparentem Quarzglas eine Verglasungsfront von Innen nach Außen fortschreitet.

Beim Erhitzen wird die Körnungsschicht verglast. Dabei werden in einem Arbeitsgang opake Außenzone und transparente Innenzone erhalten. Beim Verglasungsprozeß wandert die Verglasungsfront von Innen nach Außen. Offene Poren und Porenkanäle im Granulat werden dabei geschlossen und Gase in Richtung der Form-Innenwandung verdrängt. Aufgrund der stärkeren Temperatureinwirkung im Bereich der Innenzone (höhere Temperatur und längere Heizdauer) wird diese porenfrei oder derart porenarm, daß sie eine Dichte von mindestens 2,15 g/cm³ aufweist.

Bei der Verglasungsfront handelt es sich um einen unscharfen Grenzbereich zwischen geschmolzenem und angeschmolzenen Material. Im angeschmolzenen Material liegen offene Poren und Kanäle vor, während das geschmolzenen Material geschlossene Poren aufweist, die nicht mehr mit der Außenoberfläche verbunden sind. Dadurch, daß die Verglasungsfront von Innen nach Außen fortschreitet, werden sublimierbare Verunreinigungen in die Gasphase überführt und vor der Verglasungsfront nach außen, in Richtung noch poröser Bereiche der Körnungsschicht getrieben, wo sie entweichen können.

Da die transparente Innenzone beim Verglasen der Körnungsschicht erhalten wird, ist ein zusätzlicher Verglasungsschritt nicht erforderlich. Das erfindungsgemäße Verfahren ist daher einfach und kostengünstig durchführbar. Mechanische Spannungen, wie sie typischerweise beim lokalen Erhitzen auftreten, werden vermieden.

Durch das erfindungsgemäße Verfahren wird eine Außenzone mit hoher Opazität bzw. niedriger Transmission im IR-Bereich erhalten. Die direkte spektrale Durchlässigkeit einer 3 mm dicken Scheibe beträgt im IR-Wellenlängenbereich von 600 nm bis 2650 nm weniger als 1%. Dies wird im wesentlichen dadurch erreicht, daß die Außenzone aus einem SiO₂-Granulat hergestellt wird, das aus teilweise porösen Agglomeraten von SiO₂-Primärteilchen gebildet wird, und das eine spezifische Oberfläche (nach BET) von 0,5 m²/g bis 40 m²/g aufweist. Beim Verglasen eines derartigen SiO₂-Granulats wird opakes Quarzglas erhalten, das eine homogene Porenverteilung bei gleichzeitig hoher Porendichte und hoher spezifischer Dichte aufweist. Demgegenüber stellen sich beim Einsatz natürlicher oder synthetischer Quarzglaskörnung mit geringer spezifischer Oberfläche (zum Beispiel unterhalb der Nachweisgrenze) in erster Linie grobe Blasen bei niedriger Blasenhäufigkeit ein, was vorallem eine Undurchlässigkeit im sichtbaren Lichtspektrum erzeugt. Aufgrund der hohen Opazität im IR-Bereich zeichnet sich ein unter Einsatz eines derartigen Granulats hergestellter Quarzglastiegel durch eine Außenzone mit guter Wärmeisolierung aus.

Die dafür erforderliche Feinporigkeit in der Außenzone wird durch den Einsatz eines SiO₂-Granulats erreicht, das in Form von mindestens teilweise porösen Agglomeraten von SiO₂-Primärteilchen vorliegt. Derartige Primärteilchen werden beispielsweise durch Flammenhydrolyse oder Oxidation von Siliziumverbindungen, durch Hydrolyse organischer Siliziumverbindungen nach dem sogenannten Sol-Gel-Verfahren oder durch Hydrolyse anorganischer Siliziumverbindungen in einer Flüssigkeit erhalten. Derartige Primärteilchen lassen sich wegen ihrer geringen Schüttdichte nur schwer handhaben. Zu diesem Zweck ist eine Verdichtung mittels Granulierverfahren gebräuchlich. Beim Granulieren bilden sich durch Zusammenlagerungen der feinteiligen Primärteilchen Agglomerate mit größerem Durchmesser. Diese weisen eine Vielzahl offener Porenkanäle auf, die einen dementsprechend großen Porenraum bilden. Die einzelnen Körner eingesetzten SiO₂-Granulats werden aus derartigen Agglomeraten gebildet. Das Granulat zeichnet sich aufgrund des großen Porenraumes durch eine spezifische Oberfläche (nach BET) von 0,5 m²/g bis 40 m²/g aus. Diese tritt somit nicht als Außenoberfläche, sondern überwiegend als Innenoberfläche in Form von Porenkanälen in Erscheinung. Beim Verglasen schließt sich der größte Teil des Porenraums durch Sintern und Kollabieren. Von den vorher offenen Porenkanälen bleibt jedoch eine Vielzahl feiner, geschlossener Poren, an denen IR-Strahlung rückgestreut wird, was die hohe Opazität bzw. niedrige Transmision im IR-Bereich erzeugt. Die große Oberfläche des Granulats begünstigt außerdem die Bildung von gasförmigem Siliziummonoxid (SiO) beim Verglasen, was einem Kollabieren kleiner Poren entgegenwirkt, da in geschlossenen Poren eingeschlossene Gase nicht mehr entweichen können. Darüberhinaus ermöglicht die hohe spezifische Oberfläche eine besonders wirksame Reinigung, beispielsweise durch Thermochlorierung, vor dem Einsatz des Granulats. Denn Verunreinigungen befinden sich vorwiegend im Bereich der freien Oberfläche, von wo sie leicht entfernt und durch die offenen Porenkanäle abgeführt werden können.

Die Stampfdichte von mindestens 0,8 g/cm³ gewährleistet in erster Linie die Schüttfähigkeit des SiO₂-Granulats, während die Opazität des Quarzglases - wie oben erläutert - im wesentlichen durch die große spezifische Oberfläche, die als innere Oberfläche ausgebildet ist, bedingt ist.

Die spezifische Oberfläche des SiO₂-Granulats wird nach dem BET-Verfahren (DIN 66132) und die Stampfdichte nach DIN/ISO 787 Teil 11 ermittelt.

In einer bevorzugten Verfahrensweise wird synthetisches SiO₂-Granulat mit einer spezifischen Oberfläche (nach BET) im Bereich von 2 m²/g und 20 m²/g und mit einer Stampfdichte im Bereich von 1,0 g/cm³ bis 1,4 g/cm³ eingesetzt. Eine derartige Stampfdichte hat sich im Hinblick auf die Rieselfähigkeit und Handhabbarkeit des Granulats besonders bewährt.

In einer bevorzugten Verfahrensvariante wir ein SiO₂-Granulat in Form mindestens teilweise poröser Agglomerate von SiO₂-Primärteilchen, die eine mittlere Teilchengröße von weniger als 5 µm aufweisen, eingesetzt. Derartige Primärteilchen werden beim sogenannten "Sol-Gel-Verfahren" durch Hydrolyse organischer Siliziumverbindungen erhalten. In einer alternativen und gleichermaßen bevorzugten Verfahrensvariante wird ein SiO₂-Granulat in Form mindestens teilweise poröser Agglomerate von SiO₂-Primärteilchen, die eine mittlere Teilchengröße von weniger als 0,2 µm ausweisen, eingesetzt. Derartige, pyrogene Primärteilchen werden durch Flammenhydrolyse oder Oxidation anorganischer Siliziumverbindungen gebildet. Im Hinblick auf eine geringe Entglasungsneigung beim Verglasen sind die Primärteilchen vorzugsweise amorph.

Bei beiden Verfahrensvarianten zeichnen sich die Primärteilchen durch eine große freie Oberfläche aus. Durch Agglomeration einer Vielzahl derartiger Primärteilchen aufgrund physikalischer oder chemischer Bindungskräfte werden die Granulate im Sinne der Erfindung gebildet. Für die Granulation werden die bekannten Granulierverfahren eingesetzt, insbesondere Aufbaugranulation (Naßgranulierverfahren) oder Preßgranulation (Extrusion) einer die Primärteilchen enthaltenden Masse. Insbesondere die nach dem Sol-Gel-Verfahren hergestellten Primärteilchen liegen im Granulat in dichter Packung vor, da diese überwiegend und auch vorzugsweise sphärische Form haben. Die freie Oberfläche wird um die Kontaktflächen aneinandergrenzender Primärteilchen verringert; jedoch können sich zwischen den einzelnen Primärteilchen - wie oben erläutert - beim Verglasen geschlossene Poren ausbilden. Dadurch, daß die Primärteilchen eine mittlere Teilchengröße von weniger als 5 µm haben, ergibt sich eine entsprechend feine Porenverteilung. Die mittlere Teilchengröße wird als sogenannter D₅₀-Wert nach ASTM C1070 ermittelt.

Als besonders geeignet für den Einsatz beim erfindungsgemäßen Verfahren hat sich ein Granulat aus SiO₂-Partikeln mit inhomogener Dichteverteilung erwiesen, wobei ein Innenbereich geringerer Dichte mindestens teilweise von einem Außenbereich höherer Dichte umschlossen ist. Als SiO₂-Partikel werden hier und im folgenden die einzelnen Körner des Granulats bezeichnet; als Granulat die Gesamtheit der Partikel. Durch die inhomogene Dichteverteilung gelingt es, Gase im Innenbereich einzuschließen, die dann während des Verglasens nicht oder nur zum Teil entweichen und so zu Porenbildung und Opazität des Quarzglases beitragen. Diese Dichteverteilung wird zum Beispiel auch erhalten, wenn der Innenbereich einen Hohlraum umfaßt.

Die spezifische Oberfläche und die Stampfdichte des SiO₂-Granulats werden besonders einfach durch thermische Behandlung, die ein Sintern bei einer Temperatur im Bereich von 800 C bis 1450 °C umfaßt, eingestellt. Dabei kann auch eine höhere Dichte im Außenbereich erhalten werden. Zum Beispiel dadurch, daß bei der thermischen Behandlung ein Temperaturgradient aufrecht erhalten wird. Durch Einstellen eines Temperaturgradienten schrumpfen die Poren und Porenkanäle bevorzugt im oberflächennahen Volumenanteil der einzelnen Körner, also im Außenbereich. Dieser erhält somit eine Dichte, die höher ist als die des porösen oder hohlen Innenbereichs. Die thermische Behandlung der SiO₂-Körner wird beendet oder unterbrochen, bevor der sich anfänglich einstellende Temperaturgradient zwischen Außenbereich und Innenbereich ausgeglichen ist. Dies läßt sich beispielsweise auf einfache Weise dadurch realisieren, daß das Granulat im Durchlauf durch eine Heizzone geführt wird. Ein derartiger Temperaturgradient läßt sich bei gröberen Körnern einfacher einstellen als bei feinen Körnern, wie weiter unten näher erläutert wird.

Als günstig hat sich eine Verfahrensweise erwiesen, bei der die thermische Behandlung ein Erhitzen in chlorhaltiger Atmosphäre umfaßt. Durch die Behandlung in chlorhaltiger Atmosphäre werden Verunreinigungen, die bei der Behandlungstemperatur flüchtige Chlorverbindungen bilden, und OH-Gruppen entfernt. Die Reinheit des opaken Quarzglases wird somit verbessert, die Viskosität erhöht und die Entglasungsneigung weiter gesenkt. Die chlorhaltige Atmosphäre enthält Chlor und/oder eine Chlorverbindung. Bei einem im Sinne der Erfindung reinen Quarzglas beträgt die Gesamtheit der Verunreinigungen an Li, Na, K, Mg, Ca, Fe, Cu, Cr, Mn, Ti, und Zr insgesamt weniger als 250 Gew.-ppb. Dotierstoffe sind keine Verunreinigungen in diesem Sinn.

In einer bevorzugten Verfahrensweise umfaßt die thermische Behandlung ein Erhitzen der porösen Agglomerate bei einer Temperatur zwischen 1000 °C und 1300 °C unter stickstoffhaltiger Atmosphäre und in Gegenwart von Kohlenstoff. Durch diese Verfahrensvariante werden Granulat-Körner erhalten, an deren gesamter freier Oberfläche Stickstoff angereichert ist. Der Stickstoffeinbau wird in Gegenwart von Kohlenstoff erleichtert, der sich jedoch verflüchtigt. Es hat sich gezeigt, daß durch den Einbau von Stickstoff die Viskosität von Quarzglas erhöht wird.

Eine hohe Viskosität wird auch durch ein Granulat erreicht, das aus SiO₂-Körnern besteht, die im Bereich zwischen 5 Gew.-ppm und 20 Gew.-ppm mit Aluminium dotiert sind. Dabei wird Aluminium-Dotierung vorteilhafterweise durch feinverteilte, nanoskalige Al₂O₃-Partikel erzeugt. Dadurch wird ein homogene Verteilung des Dotierstoffs gewährleistet. Aufgrund des Einsatzes des oben beschriebenen Granulats, das aus nanoskaligen Teilchen aufgebaut ist, ist die Dotierung auch innerhalb der einzelnen Granulat-Körner gleichmäßig verteilt. Beim Einsatz herkömmlicher SiO₂-Körnung ist dies nicht möglich. Denn in dem Fall können sich zugegebene Dotierstoffe nur auf der Korn-Oberfläche ablagem, so daß sie nach dem Verglasen im Bereich der ehemaligen Korngrenzen angereichert sind. Pyrogen hergestellte Al₂O₃-Partikel sind aufgrund ihrer hohen spezifischen Oberfläche besonders gut geeignet.

Bei einem Einsatz von SiO₂-Granulat aus Körnern mit einer mittleren Korngröße im Bereich von 150 µm bis 800 µm, hat es sich als günstig erwiesen, den Feinanteil von Körnern mit einer Korngröße unterhalb von 90 µm zu vermeiden. Hierzu werden Körner mit einer Korngröße unterhalb von 90 µm aus dem Granulat entfernt, oder ihre Bildung wird bereits bei der Herstellung des Granulats unterdrückt. In einem gröberen Granulat-Korn bildet sich während des Verglasens des Formlings oder bei einer thermischen Behandlung zur Vorverdichtung des Granulats ein Temperaturgradient aus, der zu einem Dichtegradienten innerhalb des Korns mit höherer Verdichtung im Außenbereich führt und damit die Porenbildung beim Verglasen begünstigt, wie oben erläutert. Die geringe Größe feiner Körner erschwert oder verhindert hingegen die Ausbildung eines derartigen Dichtegradienten, so daß der Feinanteil zur Porenbildung nicht beträgt. Darüberhinaus beeinflußt der Feinanteil die Schrumpfung des Quarzglases beim Kollabieren der Porenkanäle und erschwert die Einhaltung vorgegebener Maße.

Vorteilhafterweise erfolgt die Ausbildung von Außenzone und Innenzone durch zonenweises Erhitzen der Körnungsschicht mittels eines Lichtbogens, wobei sich im Bereich der Innenzone eine Temperatur oberhalb von 1900 °C einstellt. Die Herstellung von Innenzone und Außenzone kann so kostengünstig in einem gemeinsamen Verfahrensschritt erfolgen.

Dabei hat es sich als günstig erwiesen, die Körnungsschicht vor dem Erhitzen auf eine Temperatur oberhalb von 1000 °C zu erwärmen. Das Vorwärmen, das bei einer Temperatur unterhalb der Schmelztemperatur des Granulats erfolgt, bewirkt eine gleichmäßigere Temperaturverteilung über die Dicke der Körnungsschicht. Dabei kann es vorteilhaft sein, das SiO₂-Granulat im Bereich der Innenzone bereits teilweise zu verglasen. Dies erleichtert die Einstellung der erforderlichen Dichte beim nachfolgenden Erhitzungsschritt.

Bevorzugt wird die opake Außenzone aus einem ersten SiO₂-Granulat geringerer Dichte, und die transparente Innenzone aus einem zweiten SiO₂-Granulat höherer Dichte hergestellt. Die Vorverdichtung des zweiten Granulats erleichtert die Einstellung der erforderlichen Dichte im Bereich der Innenzone.

Vorteilhafterweise wird im Bereich der Innenzone SiO₂-Granulat eingesetzt, das durch Tempern mindestens teilweise in synthetischen Cristobalit umgewandelt ist. Es hat sich gezeigt, daß mit der Umwandlung in Cristobalit eine Verringerung des OH-Gehaltes einhergeht. Die aus synthetischen Cristobalit enthaltendem SiO₂-Granulat hergestellte Innenzone zeichnet sich daher durch einen niedrigen OH-Gehalt aus.

In dieser Hinsicht hat es sich auch bewährt, das zweite, für die Herstellung der Innenzone eingesetzte SiO₂-Granulat vor dem Einsatz einer Dehydratationsbehandlung zu unterwerfen, und dabei einen OH-Gehalt von maximal 40 Gew.-ppm einzustellen und das derart dehydratisierte Granulat anschließend zu verglasen.

Vorteilhafterweise weist das zweite SiO₂-Granulat einen metastabilen OH-Gehalt von maximal 20 Gew.-ppm auf. Hinsichtlich der Begriffsbestimmungen für den "metastabilen OH-Gehalt" und "fest gebundene Hydroxylgruppen" wird auf die obige Definition Bezug genommen. Bei einer Innenzone mit einem metastabilen OH-Gehalt von maximal 20 Gew.-ppm ist gewährleistet, daß während des bestimmungsgemäßen Einsatzes des Quarzglastiegels keine oder wenig Hydroxylgruppen abgegeben werden. Aufgrund des geringen Gehaltes an metastabilen Hydroxylgruppen ist außerdem die Gefahr einer Porenvergrößerung und einer Blasenbildung beim Einsatz des Quarzglastiegels verringert. Dieser Effekt kann auftreten, wenn beim Erhitzen von Quarzglas Gase freigesetzt werden, die nicht mehr entweichen können.

Chemisch fest gebundene Hydroxylgruppen führen zwar nicht zu einer Porenvergrößerung beim Einsatz des Quarzglastiegels. Bevorzugt wird jedoch Granulat eingesetzt, dessen Gehalt an fest gebundenen Hydroxylgruppen maximal 40 Gew.-ppm beträgt. Quarzglas mit einem geringen OH-Gehalt hat eine höhere Viskosität als Quarzglas mit höherem OH-Gehalt. Eine hohe Viskosität verbessert die Formbeständigkeit des Quarzglastiegels bei hoher Temperatur. Da auch fest gebundene Hydroxylgruppen bei hohen Temperaturen unter Vakuum teilweise entfernt werden können, vermindert ein geringer Gehalt vermindert derartiger Hydroxylgruppen die Gefahr einer Porenvergrößerung bei einem Einsatz des Quarzglastiegels unter Vakuum.

In einer besonders bevorzugten Verfahrensweise wird auf der transparenten Innenzone eine Innenschicht aus transparentem Quarzglas erzeugt wird, indem SiO₂-Körnung in die rotierende Form eingestreut, auf der Innenzone abgelagert und dabei mittels eines Lichtbogens verglast wird. Die Innenschicht aus transparentem Quarzglas dient in erster Linie zur Verstärkung der Innenzone.

Eine weitere Verbesserung ergibt sich, wenn beim Erhitzen der Körnungsschicht im Bereich der Innenwandung der Form ein Unterdruck erzeugt wird. Durch den Unterdruck werden überschüssige Gase schnell abgeführt und die Schmelzzeit verkürzt.

Nachfolgend wird die Erfindung anhand von Ausführungsbeispielen und einer Zeichnung näher erläutert. In der Zeichnung zeigen in schematische Darstellung im einzelnen:
- **Figur 1**: eine Ausführungsform eines erfindungsgemäß hergestellten Quarzglastiegels anhand eines Schnitts durch die Tiegelwandung,
- **Figur 2**: eine erste Ausführungsform eines zum Einsatz beim erfindungsgemäßen Verfahren geeigneten SiO₂-Granulats, anhand eines Querschnitts durch ein einzelnes Granulat-Korn, und
- **Figur 3**: eine weitere Ausführungsform eines zum Einsatz beim erfindungsgemäßen Verfahren geeigneten SiO₂-Granulats, anhand eines Querschnitts durch ein einzelnes Granulat-Korn.

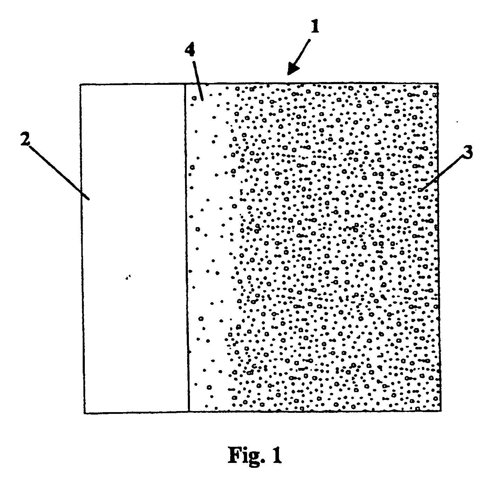

**Figur 1** zeigt einen Schnitt durch die Wandung eines erfindungsgemäß hergestellten Quarzglastiegels in schematischer Darstellung.

Der Quarzglastiegel besteht vollständig aus synthetisch hergestelltem SiO₂. Er weist einen Basiskörper auf, dem insgesamt die Bezugsziffer 1 zugeordnet ist, und eine Innenschicht 2 aus synthetischer Quarzglaskörnung. Der Basiskörper 1 besteht aus zwei Bereichen, die sich lediglich hinsichtlich ihrer Opazität bzw. Transmission unterscheiden, nämlich aus einem opaken Außenbereich 3 und einem Transparenzbereich 4. Der Basiskörper hat insgesamt eine Wandstärke von etwa 5 mm. Davon entfallen etwa 4 mm auf den opaken Außenbereich 3 und etwa 1 mm auf den Transparenzbereich 4. Der Außenbereich 3 und der Transparenzbereich 4 sind integral miteinander verbunden, so daß es keine scharfe, definierte Grenzfläche gibt.

Der Quarzglastiegel ist aus einem Granulat aus synthetischem SiO₂ hergestellt, wie dies weiter unten anhand von Beispielen näher erläutert wird.

Der Transparenzbereich 4 ist derart porenfrei oder derart porenarm, daß er eine Dichte von mindestens 2,15 g/cm³ aufweist. Diese Dichte kommt derjenigen von transparentem Quarzglas nahe. Daher entsprechen seine mechanischen und chemischen Eigenschaften denjenigen von dichtem, transparentem Quarzglas, etwa hinsichtlich der mechanischen Festigkeit und Härte, der Abrasion und der chemischen Beständigkeit.

Der Außenbereich 3 zeichnet sich hingegen durch hohe Opazität bzw. niedrige Transmission im IR-Bereich aus. Die Transmission einer 3 mm dicken Scheibe beträgt im IR-Wellenlängenbereich von 750 nm bis 4800 nm weniger als 1%. Die niedrige Transmission wird durch Feinporigkeit bei homogener Verteilung der Poren und bei gleichzeitig hoher Porendichte und hoher spezifischer Dichte erreicht. Die Porengröße im opaken Außenbereich liegt vorwiegend zwischen 5 µm und 40 µm. Der Quarzglastiegel zeichnet sich daher durch gute Wärmeisolierung und eine lange Standzeit aus.

Im folgenden wird das erfindungsgemäße Verfahren zur Herstellung eines Quarzglastiegels anhand von drei Ausführungsbeispielen näher beschrieben:

### Beispiel 1:

Pyrogenes SiO₂ mit einer spezifischen BET-Oberfläche von 70 m²/g wird unter Zusatz von 12 Gew.-ppm eines nanoskaligen Al₂O₃-Pulvers granuliert, getrocknet und gesiebt. Die Kornfraktion zwischen 160 µm und 840 µm wird in einem Drehrohrofen bei 1200 °C in einem Cl₂/HCl-Gasgemsich bei einem Durchsatz von 6 kg/h gereinigt, wobei gleichzeitig OH-Gruppen entfernt werden. Die Gehalte der Elemente Li, Na, K, Mg, Fe, Cu, Cr, Mn, Ti, und Zr liegen danach jeweils unterhalb von 10 Gew.-ppb bzw. unterhalb der jeweiligen Nachweisgrenze. Der Gesamtgehalt an diesen Verunreinigungen liegt unterhalb von 150 Gew.-ppb. Daran schließt sich eine thermische Behandlung bei 1200°C zur Desorption von Chlorgruppen an.

Das so behandelte Granulat weist eine Stampfdichte von 1,1 g/cm³ und eine BET-Oberfläche von 15 m²/g auf.

Das Granulat wird in eine rotierende Schmelzform gegeben und an deren Innenwandung zu einer Tiegel-Vorform aufgeschüttet. Die Vorform wird mittels Lichtbogens bis zu einer Schichtdicke von etwa 8 mm auf eine Temperatur von ca. 1500 °C erwärmt. Die einzelnen Granulat-Körner werden dabei durch Sintern in sich selbst weiter verdichtet, jedoch ohne daß die Schüttung insgesamt verschmolzen wird. Durch Ausbildung eines Temperaturgradienten ist eine Desorption von lose gebundenen Gasen, insbesondere von Hydroxylgruppen, möglich.

Anschließend wird die so vorbereitete Tiegel-Vorform mittels eines Lichtbogens zonenweise verglast, indem eine Verglasungsfront von Innen nach Außen fortschreitet und dabei den einen Transparenzbereich 4 mit einer radialen Ausdehnung von etwa 1 mm und einen verglasten, aber opaken Außenbereich 3 erzeugt. Aufgrund der stärkeren Temperatureinwirkung im Transparenzbereich 4 (höhere Temperatur und längere Heizdauer) wird dieser porenfrei oder derart porenarm, daß er eine Dichte von mindestens 2,15 g/cm³ aufweist.

Der Außenbereich 3 zeichnet sich hingegen durch hohe Opazität bzw. niedrige Transmission im IR-Bereich aus. Dies wird im wesentlichen dadurch erreicht, daß das eingesetzte SiO₂-Granulat aus teilweise porösen Agglomeraten von SiO₂-Primärteilchen gebildet wird und eine relativ hohe spezifische BET-Oberfläche (15 m²/g) aufweist.

Der so hergestellte Quarzglastiegel zeichnet sich insbesondere durch hohe Reinheit und hohe Opazität (niedrige Transmission) im IR-Bereich aus. Die Porengröße des opaken Außenbereichs liegt vorwiegend zwischen 5 und 40 µm.

### Beispiel 2:

Ein Quarzglastiegel wird in Beispiel 1 beschrieben hergestellt. Anschließend wird der Transparenzbereich 4 durch Aufbringen einer transparenten Innenschicht 2 verstärkt. Hierzu wird ein SiO₂-Granulat eingesetzt, das mittels Extrusion eines Na-Silikates (Wasserglas) gewonnen wird und dessen spezifische BET-Oberfläche 700 m²/g und dessen Stampfdichte 0,45 g/cm³ beträgt. Die Korngröße liegt im Bereich zwischen 250 µm und 500 µm. Das Extrudat wird mittels Heißchlorierung bei 1200 °C gereinigt und thermisch verdichtet. Alkali-Reste werden dabei auf Gehalte im Bereich der Nachweisgrenze reduziert.

Die spezifische Oberfläche nach BET (Brunauer-Emmett-Teller) des Granulats (Extrudats) beträgt danach 38 m²/g und die Stampfdichte 1,11 g/cm³.

Anschließend wird das Extrudat in einer zweiten thermischen Behandlung von seiner amorphen Struktur in eine kristalline Struktur (Cristobalit) umgewandelt.

Mittels diesem synthetischen Cristobalit wird mittels Einstreuverfahren und Lichtbogenschmelzen eine Innenschicht 2 aufgeschmolzen und damit eine Schichtverstärkung des Transparenzbereich 4 bis auf eine Schichtdicke von insgesamt 3 mm erreicht.

Die Innenschicht 2 zeigt einen homogenen Aufbau und weist einen Hydroxylionengehalt von 20 Gew.-ppm auf. Beim bestimmungsgemäßen Einsatz wurde weder eine Rekristallisation noch eine Porenvergrößerung beobachtet.

### Beispiel 3:

Ein Quarzglastiegel wird in Beispiel 1 beschrieben hergestellt. Anschließend wird der Transparenzbereich 4 durch Aufbringen einer transparenten Innenschicht 2 verstärkt.

Hierzu wird das gleiche SiO₂-Granulat, das für die Tiegelherstellung eingesetzt wurde, bei 1420°C bei einer Haltezeit von 1 Stunde unter Wasserstoff verglast. Metastabile OH-Gruppen werden unmittelbar vor dem Einsatz des verglasten Granulats durch Tempern im Vakuum bei 10⁻² mbar bei 1000 °C entfernt.

Das so vorbehandelte SiO₂-Granulat wird zur Erzeugung einer Innenschicht 2 mittels Einstreuverfahren und Lichtbogenschmelzen in den Quarzglastiegel eingestreut und aufgeschmolzen.

Im sogenannten "Vakuum-Bake-Test" (1600 °C, 4 h, Vakuum) zeigte sich weder Porenwachstum, noch eine Kristallisationsneigung.

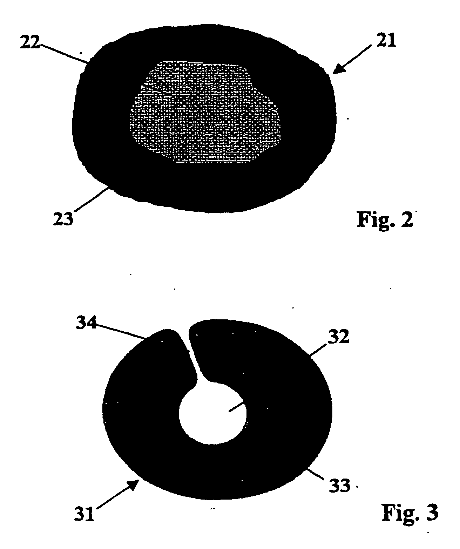

Das für die Durchführung des beschriebenen Verfahrens eingesetzte SiO₂-Granulat wird nachfolgend anhand **Figur 2** näher beschreiben. In Figur 2 ist schematisch ein einzelnes, bevorzugtes Korn 21 des eingesetzten Granulats dargestellt. Bei dem rundlichen Granulat-Korn 21, bestehend aus nanoskaligen SiO₂-Teilchen ist ein zentraler Bereich 22 geringerer Dichte von einer Außenschicht 23 mit höherer Dichte umgeben. Die Dichte im zentralen Bereich beträgt etwa 40 % der Dichte von transparentem Quarzglas, in der Außenschicht beträgt sie etwa 60% davon. Die Grenzfläche zwischen zentralem Bereich 22 und Außenschicht 23 ist fließend. Der Korn-Durchmesser beträgt 420 µm, die Dicke der Außenschicht 23 etwa 100 µm.

Die Herstellung des Granulats erfolgt mittels eines üblichen Naßgranulierverfahrens unter Einsatz eines Mischers. Aus amorphen, nanoskaligen, durch Flammenhydrolyse von SiCl₄ erzeugten, pyrogenen SiO₂-Partikeln, die eine spezifische Oberfläche (nach BET) von 60 m²/g aufweisen, wird eine wäßrige Suspension hergestellt, der unter fortwährendem Rühren Feuchtigkeit entzogen wird, bis diese unter Bildung einer körnigen Masse zerfällt. Nach dem Trocknen liegt die spezifische Oberfläche (nach BET) des so erhaltenen Granulats bei 50 m²/g, wobei die rundlichen Granulat-Körner Durchmesser im Bereich zwischen 160 µm und 840 µm aufweisen. Das SiO₂-Granulat wird anschließend im Durchlauf bei einer Temperatur von ca. 1200 °C in chlorhaltiger Atmosphäre thermisch vorverdichtet. Dabei wird das Granulat gleichzeitig gereinigt, wobei die Reinigung mittels Chlor besonders effektiv ist, da die Oberfläche der SiO₂-Partikel über die Porenkanäle für das Reinigungsgas zugänglich ist und die gasförmigen Verunreinigungen leicht entfernt werden können. Gleichzeitig werden Hydroxylgruppen entfernt. Die Behandlung erfolgt in einem Quarzglas-Drehrohr. Der Durchsatz beträgt hierbei 10 kg/h. Dabei bildet sich in den einzelnen Granulat-Körnern ein Temperaturgradient aus, der zu den unterschiedlichen Dichten von zentralem Bereich 22 und Außenschicht 23 führt.

Das nach dieser Vorbehandlung erhaltene SiO₂-Granulat zeichnet sich durch eine spezifische BET-Oberfläche von 25 m²/g und eine Stampfdichte von 1,18 g/cm³ aus. Der mittlere Korndurchmesser liegt bei etwa 420 µm, wobei darauf geachtet wird, daß ein Feinanteil mit einem Durchmesser unterhalb von 90 µm - der hier jedoch herstellungsbedingt nicht vorliegt - vor dem Einsatz zur Herstellung von opakem Quarzglas entfernt wird. Der Gesamtgehalt der Verunreinigungen an Li, Na, K, Mg, Ca, Fe, Cu, Cr, Mn, Ti, und Zr beträgt weniger als 200 Gew.-ppb.

Das so hergestellte Granulat aus amorphen, nanoskaligen SiO₂-Partikeln kann für die Herstellung eines Quarzglastiegels, wie er in Figur 1 beschrieben ist, eingesetzt werden. Aufgrund dessen, daß die einzelnen Granulat-Körner durch Zusammenlagerung einer Vielzahl von Primärteilchen gebildet sind, die eine sehr geringe Teilchengröße haben, wird beim Verglasen eine entsprechend feine und homogene Porenverteilung ermöglicht, wie dies weiter oben näher erläutert.

In **Figur 3** ist schematisch ein einzelnes Sprühkorn 31 dargestellt, wie es typisch für ein Sprühgranulat ist. Das Sprühkom 31 liegt als Agglomerat von SiO₂-Primärteilchen vor. Es weist einen Hohlraum 32 auf, der einer Außenschicht 33 umgeben ist. Auf der Außenschicht 33 ist ein Einzugstrichter ausgebildet, der in einem engen Kanal 34 in den Hohlraum 32 mündet. Der Außendurchmesser des Sprühkorns 31 beträgt etwa 300 µm und die Dicke der Außenschicht 33 etwa 100 µm.

Im folgenden wird die Herstellung diese Sprühgranulats näher beschrieben:

Hochreine, pyrogene, nanoskalige SiO₂-Primärteilchen mit einer spezifischen Oberfläche (nach BET) von 70 m²/g werden in deionisiertem Wasser dispergiert. Es werden 12 Gew.-ppm Aluminium in Form von pyrogenem Al₂O₃ hinzugegeben. Die Suspension wird dabei auf ein Litergewicht von 1380 g/l eingestellt. Die Schlickerviskosität beträgt 450 mPas. Unter Einsatz eines handelsüblichen Sprühtrockners (Firma Dorst, Typ D400) wird die Suspension bei einer Heißlufttemperatur von 380 °C und einem Schlickerdruck von 10,5 bar versprüht. Dabei wird ein Sprühgranulat mit einem mittleren Korndurchmesser von 330 µm und einer Restfeuchte von 0,3% erhalten. Die spezifische Oberfläche (nach BET) beträgt 54 m²/g und das Schüttgewicht liegt bei 0,6 g/cm³. Das Granulat wird anschließend bei 1200 °C im Durchlauf mit einem Durchsatz von 6,1 kg/h in einem HCl/Cl₂-Gasgemisch gereinigt und thermisch verfestigt.

Die spezifische BET-Oberfläche beträgt nach dieser Behandlung 20 m²/g, die Schüttdichte 0,8 g/cm³ und die Stampfdichte 0,92 g/cm³. Der Feinanteil mit einem Durchmesser unterhalb von 90 µm wird hier herstellungsbedingt bereits bei der Sprühgranulation mittels eines Zyklons abgetrennt. Der Gesamtgehalt der Verunreinigungen an Li, Na, K, Mg, Ca, Fe, Cu, Cr, Mn, Ti und Zr beträgt weniger als 200 Gew.-ppb.

Das so hergestellte Sprühgranulat aus amorphen, nanoskaligen SiO₂-Partikeln kann ebenfalls für die Herstellung eines Quarzglastiegels, wie er in Figur 1 beschrieben ist, eingesetzt werden. Aufgrund dessen, daß die einzelnen Sprühkömer durch Zusammenlagerung einer Vielzahl von Primärteilchen gebildet sind, die eine sehr geringe Teilchengröße haben, wird beim Verglasen eine entsprechend feine und homogene Porenverteilung ermöglicht. Dies wird noch dadurch erleichtert, daß durch den Hohlraum 32 ein zusätzlicher, nahezu abgeschlossener Gasraum gebildet wird, der beim Verglasen zumindest teilweise erhalten bleibt, weil das eingeschlossene Gas während des Verglasens nur zum Teil entweichen kann und so zu Porenbildung und Opazität beiträgt.

## Patentansprüche

1. Verfahren zur Herstellung eines Quarzglastiegels, durch Bereitstellen einer um eine Rotationssachse rotierbaren und eine Innenwandung aufweisenden Form, Einbringen von SiO₂-Körnung in die Form unter Bildung einer Körnungsschicht auf der Innenwandung der Form, und Erhitzen der Körnungsschicht von Innen nach Außen unter Rotation der Form und unter Bildung eines verglasten Tiegelkörpers mit opaker Außenzone, **dadurch gekennzeichnet, daß** als SiO₂-Körnung ein aus mindestens teilweise porösen Agglomeraten synthetisch hergestellter SiO₂-Primärteilchen gebildetes SiO₂-Granulat (21; 31) eingesetzt wird, das eine spezifische Oberfläche (nach BET) im Bereich von 0,5 m²/g bis 40 m²/g und ein Stampfdichte von mindestens 0,8 g/cm³ aufweist, wobei das Erhitzen derart erfolgt, daß unter Ausbildung einer Innenzone aus transparentem Quarzglas eine Verglasungsfront von Innen nach Außen fortschreitet.

2. Verfahren nach Anspruch 1, **dadurch gekennzeichnet, daß** SiO₂-Granulat mit einer spezifischen Oberfläche (nach BET) im Bereich zwischen 2 m²/g und 20 m²/g und mit einer Stampfdichte im Bereich von 1,0 g/cm³ bis 1,4 g/cm³ eingesetzt wird.

3. Verfahren nach Anspruch 1 oder 2, **dadurch gekennzeichnet, daß** ein SiO₂-Granulat (21; 31) in Form mindestens teilweise poröser Agglomerate von SiO₂-Primärteilchen, die eine mittlere Teilchengröße im Bereich von 0,5 µm bis 5 µm aufweisen, eingesetzt wird.

4. Verfahren nach Anspruch 1 oder 2, **dadurch gekennzeichnet, daß** ein SiO₂-Granulat (21; 31) in Form mindestens teilweise poröser Agglomerate von SiO₂-Primärteilchen, die eine mittlere Teilchengröße von weniger als 0,2 µm ausweisen, eingesetzt wird.

5. Verfahren nach einem der Ansprüche 1 bis 4, **dadurch gekennzeichnet, daß** Granulat (21; 31) aus SiO₂-Partikeln mit inhomogener Dichteverteilung, bei denen ein Innenbereich (22; 32) geringerer Dichte mindestens teilweise von einem Außenbereich (23; 33) höherer Dichte umschlossen ist, eingesetzt wird.

6. Verfahren nach einem der Ansprüche 1 bis 5, **dadurch gekennzeichnet, daß** die spezifische Oberfläche und die Stampfdichte des SiO₂-Granulats (21; 31) durch thermische Behandlung, die ein Sintern bei einer Temperatur im Bereich von 800°C bis 1450 °C umfaßt, eingestellt werden.

7. Verfahren nach Anspruch 6, **dadurch gekennzeichnet, daß** die thermische Behandlung ein Erhitzen in chlorhaltiger Atmosphäre umfaßt.

8. Verfahren nach Anspruch 6 oder 7, **dadurch gekennzeichnet, daß** die thermische Behandlung bei einer Temperatur zwischen 1000°C und 1300°C unter stickstoffhaltiger Atmosphäre und in Gegenwart von Kohlenstoff erfolgt.

9. Verfahren nach einem der Ansprüche 1 bis 8, **dadurch gekennzeichnet, daß** SiO₂-Granulat (21; 31) eingesetzt wird, das im Bereich zwischen 5 Gew.-ppm und 20 Gew.-ppm mit Aluminium dotiert ist.

10. Verfahren nach einem der Ansprüche 1 bis 9, **dadurch gekennzeichnet, daß** ein SiO₂-Granulat (21; 31) aus Partikeln mit einer mittleren Partikelgröße im Bereich von 150 µm bis 800 µm eingesetzt wird, wobei ein Feinanteil von Partikeln mit einer Partikelgröße unterhalb von 90 µm vermieden wird.

11. Verfahren nach einem der Ansprüche 1 bis 10, **dadurch gekennzeichnet, daß** die Ausbildung von Außenzone (3) und Innenzone (4) durch zonenweises Erhitzen der Körnungsschicht mittels eines Lichtbogens erfolgt, wobei sich im Bereich der Innenzone (4) eine Temperatur oberhalb von 1900 °C einstellt.

12. Verfahren nach Anspruch 11, **dadurch gekennzeichnet, daß** die Körnungsschicht vor dem Erhitzen auf eine Temperatur oberhalb von 1000 °C erwärmt wird.

13. Verfahren nach Anspruch 12, **dadurch gekennzeichnet, daß** das SiO₂-Granulat (21; 31) im Bereich der Innenzone (4) beim Erwärmen verglast wird.

14. Verfahren nach einem der Ansprüche 1 bis 13, **dadurch gekennzeichnet, daß** die opake Außenzone (3) aus einem ersten SiO₂-Granulat geringerer Dichte, und die transparente Innenzone aus einem zweiten SiO₂-Granulat höherer Dichte hergestellt wird.

15. Verfahren nach Anspruch 14, **dadurch gekennzeichnet, daß** das zweite SiO₂-Granulat (21; 31) vor dem Einsatz einer Dehydratationsbehandlung unterworfen, und dabei ein OH-Gehalt von maximal 40 Gew.-ppm eingestellt wird, und daß das derart dehydratisierte Granulat (21; 31) verglast wird.

16. Verfahren nach Anspruch 15, **dadurch gekennzeichnet, daß** das zweite SiO₂-Granulat einen metastabilen OH-Gehalt von maximal 20 Gew.-ppm aufweist.

17. Verfahren nach einem der Ansprüche 1 bis 16, **dadurch gekennzeichnet, daß** im Bereich der Innenzone (4) SiO₂-Granulat eingesetzt wird, das durch Tempern mindestens teilweise in synthetischen Cristobalit umgewandelt ist.

18. Verfahren nach einem der Ansprüche 1 bis 17, **dadurch gekennzeichnet, daß** auf der transparenten Innenzone (4) eine Innenschicht (2) aus transparentem Quarzglas erzeugt wird, indem SiO₂-Körnung in die rotierende Form eingestreut, auf der Innenzone (4) abgelagert und dabei mittels eines Lichtbogens verglast wird.

19. Verfahren nach einem der Ansprüche 1 bis 18, **dadurch gekennzeichnet, daß** beim Erhitzen der Körnungsschicht im Bereich der Innenwandung der Form ein Unterdruck erzeugt wird.

## Claims

1. A method for producing a quartz glass crucible by providing a mold which is rotatable about an axis of rotation and has an inner wall, introducing SiO₂ granules into the mold with formation of a granular layer on the inner wall of the mold, and heating the granular layer from the inside to the outside with rotation of the mold and with formation of a vitrified crucible body comprising an opaque outer zone, **characterized in that** the SiO₂ granules are an SiO₂ granulate (21; 31) formed from at least partly porous agglomerates of synthetically produced SiO₂ primary particles, the SiO₂ granulate having a specific BET surface area ranging from 0.5 m²/g to 40 m²/g and an apparent density of at least 0.8 g/cm³, heating being carried out such that a vitrification front advances from the inside to the outside with formation of an inner zone of transparent quartz glass.

2. The method according to claim 1, **characterized in that** SiO₂ granulate is used having a specific BET surface area ranging from 2 m²/g to 20 m²/g and an apparent density ranging from 1.0 g/cm³ to 1.4 g/cm³.

3. The method according to claim 1 or 2, **characterized in that** SiO₂ granulate (21; 31) is used in the form of at least partly porous agglomerates of SiO₂ primary particles having a mean particle size ranging from 0.5 µm to 5 µm.

4. The method according to claim 1 or 2, **characterized in that** SiO₂ granulate (21; 31) is used in the form of at least partly porous agglomerates of SiO₂ primary particles having a mean particle size of less than 0.2 µm.

5. The method according to any one of claims 1 to 4, **characterized in that** granulate (21; 31) is used which is composed of SiO₂ particles having an inhomogeneous density distribution, in which an inner region (22; 32) of lower density is at least partly enclosed by an outer region (23; 33) of higher density.

6. The method according to any one of claims 1 to 5, **characterized in that** the specific surface area and the apparent density of the SiO₂ granulate (21; 31) are set by thermal treatment comprising sintering at a temperature ranging from 800°C to 1450°C.

7. The method according to claim 6, **characterized in that** the thermal treatment comprises heating in a chlorine-containing atmosphere.

8. The method according to claim 6 or 7, **characterized in that** the thermal treatment is carried out at a temperature between 1000°C and 1300°C in a nitrogen-containing atmosphere and in the presence of carbon.

9. The method according to any one of claims 1 to 8, **characterized in that** SiO₂ granulate (21; 31) is used which is doped with aluminum in the range between 5 wt ppm and 20 wt ppm.

10. The method according to any one of claims 1 to 9, **characterized in that** SiO₂ granulate (21; 31) is used which is composed of particles having a mean particle size in the range of 150 µm to 800 µm, an amount of fine particles with a particle size below 90 µm being avoided.

11. The method according to any one of claims 1 to 10, **characterized in that** outer zone (3) and inner zone (4) are formed by zonewise heating of the granular layer by means of an electric arc, a temperature above 1900°C being set in the area of the inner zone (4).

12. The method according to claim 11, **characterized in that** prior to heating the granular layer is heated up to a temperature above 1000°C.

13. The method according to claim 12, **characterized in that** the SiO₂ granulate (21; 31) is vitrified in the area of the inner zone (4) during heating up.

14. The method according to any one of claims 1 to 13, **characterized in that** the opaque outer zone (3) is made from a first SiO₂ granulate of lower density and the transparent inner zone from a second SiO₂ granulate of higher density.

15. The method according to claim 14, **characterized in that** the second SiO₂ granulate (21; 31) is subjected to a dehydration treatment prior to use, and an OH content of not more than 40 wt ppm is set in this process, and that the granulate (21; 31) dehydrated in this manner is vitrified.

16. The method according to claim 15, **characterized in that** the second SiO₂ granulate has a metastable OH content of not more 20 wt ppm.

17. The method according to any one of claims 1 to 16, **characterized in that** SiO₂ granulate which is converted by annealing at least in part into synthetic cristobalite is used in the area of the inner zone (4).

18. The method according to any one of claims 1 to 17, **characterized in that** an inner layer (2) of transparent quartz glass is produced on the transparent inner zone (4) **in that** SiO₂ granules are spread into the rotating mold, deposited on the inner zone (4) and vitrified by means of an electric arc.

19. The method according to any one of claims 1 to 18, **characterized in that** a negative pressure is produced during heating of the granular layer in the area of the inner wall of the mold.

## Revendications

1. Procédé pour la fabrication d'un creuset en verre de quartz, par préparation d'un moule présentant une paroi interne et rotatif autour d'un axe de rotation, l'apport de granulés de SiO₂ dans le moule par formation d'une couche de granulé sur la paroi interne du four, et chauffage de la couche de granulé de l'intérieur vers l'extérieur sous rotation du moule et sous formation d'un corps de creuset vitrifié avec une zone externe opaque, **caractérisé en ce qu'**en tant que granulé de SiO₂, il est utilisé un agglomérat au moins partiellement poreux de granulé (21:31) de SiO₂ formé à partir de particules primaires de SiO2 fabriquées synthétiquement; granulé qui présente une surface spécifique (selon BET) comprise entre 0,5 m²/g et 40 m²/g et une densité de remplissage à l'état tassé d'au moins 0,8 g/cm³, le chauffage s'effectuant de sorte que sous formation d'une zone interne en verre de quartz transparent, un front de vitrification progressant de l'intérieur vers l'extérieur.

2. Procédé selon la revendication 1, **caractérise en ce que** le granulé de SiO₂ est utilisé avec une surface spécifique (selon BET) comprise entre 2m²/g et 20 m²/g et une densité de remplissage à l'état tassé comprise entre 1,0 g/cm³ et 1,4 g/cm³.

3. Procédé selon la revendication 1 ou 2, **caractérisé en ce qu'**un granulé de SiO₂ est utilisé lequel présente une grosseur moyenne de particules comprise entre 0,5 µm et 5 µm.

4. Procédé selon la revendication 1 ou 2, **caractérisé en ce qu'**un granulé de SiO₂ est utilisé lequel présente une grosseur moyenne de particules inférieure à 0,2 µm.

5. Procédé selon l'une des revendications 1 à 4, **caractérisé en ce qu'**on utilise un granulé (21:31) en particule de SiO2 de répartition de densité inhomogène où une zone interne (22:32) de densité inférieure est enrobée au moins partiellement dans une zone interne (23:33) de densité plus importance.

6. Procédé selon l'une des revendications 1 à 5 **caractérisé en ce que** la surface spécifique et la densité de remplissage à l'état tassé du granulé de SiO₂ (21:31) sont réglées par traitement thermique qui comprend un frittage à une température comprise entre 800°C et 1450°C.

7. Procédé selon la revendication 6, **caractérisé en ce que** le traitement thermique comprend un chauffage sous une atmosphère à base de chlore.

8. Procédé selon la revendication 6 ou 7, **caractérisé en ce que** le traitement thermique s'effectue à une température comprise entre 1000°C et 1300°C sous une atmosphère à base d'azote et en présence de carbone.

9. Procédé selon l'une des revendications 1 à 8, **caractérisé en ce que** le granulé de SiO₂ (21:31) est utilisé lequel est doté d'aluminium compris entre 5 ppm en poids et 20 ppm en poids.

10. Procédé selon l'une des revendications 1 à 10, **caractérisé en ce qu'**un granuler de SiO₂ (21:31) se composant de particules de taille comprise entre 150 µm et 800 µm est utilisé, de fines particules de taille inférieure à 90 µm étant évitées.

11. Procédé selon l'une des revendications 1 à 10, **caractérisé en ce que** la formation de la zone externe (3) et de la zone interne (4) s'effectue par chauffage par zone de la couche de granulé au moyen d'un arc, une température supérieure à 1900°C étant réglée à proximité de la zone interne (4).

12. Procédé selon la revendication 11, **caractérisé en ce que** la couche de granulé est échauffée avant le chauffage à une température supérieure à 1000°C.

13. Procédé selon la revendication 12, **caractérisé en ce que** le granulé de SiO₂ (21:31) est vitrifié à proximité de la zone interne (4) lors de l'échauffement.

14. Procédé selon l'une des revendications 1 à 13, **caractérisé en ce que** la zone externe opaque (3) est fabriquée à partir d'un premier granulé de SiO2 de densité inférieure et la zone interne transparente d'un granulé de SiO₂ de densité supérieure.

15. Procédé selon la revendication 14, **caractérisé en ce que** le second granulé de SiO₂ (21:31) est soumis avant l'utilisation à un traitement de déshydratation et pour ce faire une teneur en OH de maximal 40 ppm en poids et **en ce que** le granulé déshydraté (21:31) est vitrifié.

16. Procédé selon la revendication 15, **caractérisé en ce que** le second granulé de SiO₂ présente une teneur en OH métastable de maximum 20 ppm en poids.

17. Procédé selon l'une des revendications 1 à 16, **caractérisé en ce que** le granulé de SiO₂ est utilisé dans la zone intérieure (4), lequel est transformé par recuit au moins partiellement en cristobalite synthétique.

18. Procédé selon l'une des revendications 1 à 17, **caractérisé en ce que** il est généré sur la zone intérieure transparente (4), une couche interne (2) en verre transparent dans le fait que le granulé de SiO₂ est pulvérisé dans le moule rotatif, se dépose sur la zone interne (4) et est vitrifié par arc.

19. Procédé selon l'une des revendications 1 à 18, **caractérisé en ce que** lors du chauffage de la couche de granulé, il est produit une dépression dans la zone de la paroi interne du moule.
